# DEMANDE DE BREVET EUROPEEN

(11) **EP 0 645 954 A1**
(43) Date de publication de la demande: **29.03.1995**
(21) Numéro de dépôt: 94410061.9
(22) Date de dépôt: 03.08.1994
(51) Int. Cl.: H05K 5/00

(54) **Boîtier compact pour circuit électronique**

(30) Priorité: 06.08.1993 FR 9309927
(71) Demandeur: SEXTANT Avionique, F-92366 Meudon la Forêt Cedex (FR)
(72) Inventeur: Bedouet, Bernard, F-26500 Bourg-Les-Valence (FR)
(74) Mandataire: de Beaumont, Michel

(57) **Abrégé**

La présente invention concerne un boîtier comprenant un circuit électronique de base (12-1) monté sur un circuit imprimé (12) muni de broches (12-2) destinées à connecter le circuit de base à des éléments externes au boîtier. Le boîtier est fermé par un couvercle isolant (14) muni de trous (14-1) traversés par les broches. Le couvercle est un circuit imprimé sur lequel est monté un circuit électronique secondaire (15), les trous étant métallisés pour permettre la connexion du circuit secondaire au circuit de base par l'intermédiaire des broches.

## Description

La présente invention concerne les boîtiers pour circuits électroniques et en particulier les boîtiers compacts pour des circuits électroniques de faible encombrement, par exemple réalisés selon la technique des circuits hybrides, comprenant des broches de connexion soudables permettant de monter ces boîtiers directement sur un circuit imprimé.

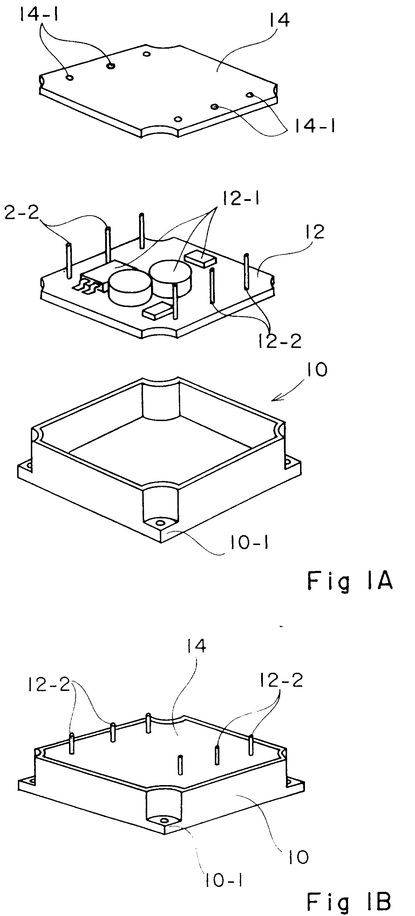

La figure 1A représente une vue éclatée d'un tel boîtier compact classique. Ce boîtier comprend une boîte 10 de forme générale parallélépipédique aplatie dont l'une des grandes faces, la face supérieure dans les figures, est ouverte. Par la face ouverte de la boite 10 est inséré un circuit imprimé 12 épousant généralement la forme interne de la boite 10. Sur le circuit imprimé 12 sont montés les composants 12-1 d'un circuit électronique ainsi que des broches de connexion 12-2 s'étendant verticalement.

Lorsque le circuit imprimé 12 est disposé dans la boite 10, on remplit éventuellement la boite d'une résine polymérisable destinée à maintenir le circuit imprimé 12, et l'on place par dessus le circuit imprimé 12 un couvercle 14 épousant la forme intérieure de la boîte 10 et comprenant des trous 14-1 par lesquels passent les broches 12-2. Le couvercle 14 peut être serti sur la boîte 10 ou bien être collé par la résine précédemment versée dans la boîte 10 pour maintenir le circuit imprimé 12. La boîte 10 peut aussi être remplie de résine une fois que le circuit imprimé 12 et le couvercle 14 sont placés, en coulant la résine par un orifice, non représenté, prévu à cet effet.

La figure 1B représente l'allure du boîtier ainsi obtenu. On obtient un boîtier compact muni de broches de connexion 12-2 à souder. Le boîtier peut être directement monté sur un circuit imprimé comme un composant électronique classique. Le boîtier pourra éventuellement être fixé sur une paroi et être relié à des éléments environnants par des fils soudés aux broches 12-2. Pour fixer le boîtier, la boite 10 est, par exemple, munie d'une semelle 10-1 dont les coins sont munis de trous contournés par les parois latérales de la boite. Ainsi, on peut fixer le boîtier sur une paroi en plaçant des vis dans les coins du boîtier.

Si le circuit électronique monté dans le boîtier dissipe une énergie importante, la boîte 10 est de préférence métallique, ce qui permet d'utiliser la boîte 10 comme dissipateur thermique et éventuellement de fixer ce boîtier sur un dissipateur thermique plus important. Par contre, si le circuit à monter dans le boîtier dissipe une faible énergie, la boite 10 peut être en matière plastique.

Les circuits montés dans des boîtiers compacts tels que celui que l'on vient de décrire sont divers et variés. On peut vouloir monter dans de tels boîtiers une famille de circuits comprenant des éléments de base communs à tous les circuits de la famille et des éléments secondaires qui diffèrent d'un circuit à l'autre de la même famille ou qui sont éventuellement optionnels.

A l'heure actuelle, on réalise un modèle de circuit imprimé par circuit différent d'une même famille. Pour diminuer les coûts (fabrication, stock...) que cela entraîne, on est parfois amené à réaliser un modèle unique de circuit imprimé prévu pour recevoir le circuit électronique de base ainsi que tous les circuits électroniques secondaires envisageables, les circuits secondaires, non nécessaires, n'étant pas montés sur le circuit imprimé.

Toutefois, cette solution est particulièrement coûteuse si la plupart des circuits fabriqués comprennent seulement le circuit de base, et elle augmente en tout cas l'encombrement des boîtiers.

Un objet de la présente invention est de prévoir un boîtier du type précédemment décrit qui permette de réduire notablement le coût de fabrication d'une série de boîtiers comprenant des circuits d'une même famille.

Cet objet est atteint grâce à un boîtier comprenant un circuit électronique de base monté sur un circuit imprimé muni de broches destinées à connecter le circuit de base à des éléments externes au boîtier, le boîtier étant fermé par un couvercle isolant muni de trous traversés par lesdites broches. Le couvercle est un circuit imprimé sur lequel est monté un circuit électronique secondaire, lesdits trous étant métallisés de manière à permettre la connexion du circuit secondaire au circuit de base par l'intermédiaire desdites broches.

Selon un mode de réalisation de la présente invention, le circuit imprimé formant couvercle est muni de broches destinées à connecter le circuit secondaire à des éléments externes au boîtier.

Selon un mode de réalisation de la présente invention, le circuit secondaire comprend des composants montés en surface sur le circuit imprimé formant couvercle, du côté intérieur du boîtier.

Selon un mode de réalisation de la présente invention, le circuit secondaire est optionnel.

Selon un mode de réalisation de la présente invention, le circuit de base est un convertisseur continu-continu et le circuit secondaire un prérégulateur à relier à l'entrée du convertisseur continu-continu.

Selon un mode de réalisation de la présente invention, le circuit de base est un réseau de résistances commutables par des interrupteurs et le circuit secondaire un circuit de commande desdits interrupteurs.

Ces objets, caractéristiques et avantages ainsi que d'autres de la présente invention seront exposés en détail dans la description suivante de modes de réalisation particuliers faite, à titre non limitatif, en relation avec les figures jointes parmi lesquelles :
la figure 1A représente une vue éclatée d'un boîtier compact classique de circuit électronique ;
la figure 1B représente une vue montée d'un tel boîtier compact ;
la figure 2A représente une vue éclatée d'un mode de réalisation de boîtier compact selon la présente invention ;
la figure 2B représente un tel boîtier compact monté ;
la figure 3 représente un exemple de circuit de base et de circuit secondaire à monter dans un boîtier compact ; et
la figure 4 représente un autre exemple de circuit de base et de circuit secondaire à monter dans un boîtier compact.

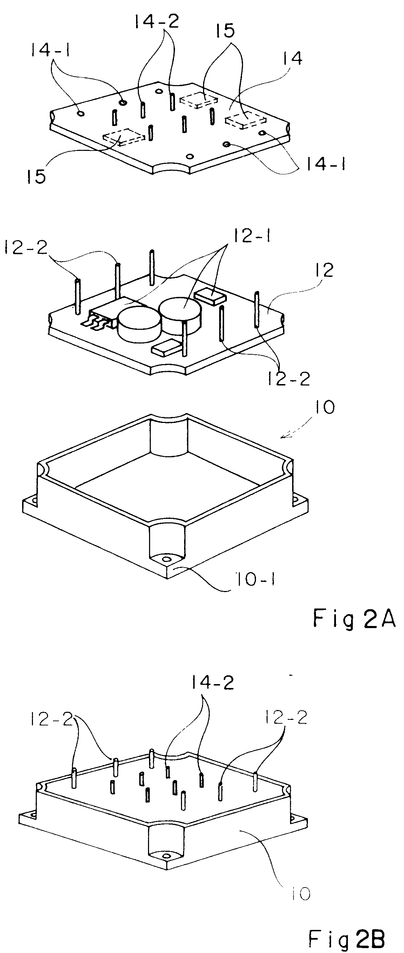

Dans les figures 2A et 2B, des mêmes éléments qu'aux figures 1A et 1B sont désignés par des mêmes références.

A la figure 2A, un circuit électronique de base est constitué des composants 12-1 précédemmment mentionnés montés sur le circuit imprimé 12 qui est inséré dans la boîte 10. Le circuit imprimé 12 est toujours muni des broches de connexion 12-2 permettant de relier le circuit de base à l'extérieur du boîtier.

Selon l'invention, le couvercle 14 est un circuit imprimé sur lequel sont montés les composants 15 d'un circuit électronique secondaire ou optionnel. Les trous 14-1 sont métallisés, ce qui permet de relier adéquatement les composants 15 aux composants 12-1 du circuit de base par les broches de connexion 12-2, une fois que l'ensemble est monté. En outre, le circuit imprimé servant de couvercle 14 est muni de broches de connexion 14-2 spécifiques au circuit secondaire et permettant de relier celui-ci à des éléments externes.

La figure 2B représente le boîtier selon l'invention une fois que tous ses éléments ont été montés. Le montage des divers éléments de ce boîtier est effectué de la manière décrite en relation avec la figure 1A. Toutefois, pour assurer le contact entre les broches de connexion 12-2 et les trous métallisés 14-1, ces broches 12-2 sont soudées sur le circuit imprimé couvercle 14.

De préférence, les composants 15 sont montés selon la technique des circuits hybrides ou de montage en surface sous le couvercle 14, du côté intérieur de la boîte 10, de manière que ces composants ne soient pas exposés à l'extérieur.

Avec un boîtier selon l'invention, si l'on souhaite fabriquer une série de circuits d'une même famille, on prévoit autant de circuits imprimés 12 identiques que de circuits à fabriquer et on prévoit autant de circuits imprimés couvercle 14 qu'il faut de circuits secondaires dans la série. Ceci diminue notablement le coût de fabrication, notamment dans le cas où l'on fabrique un grand nombre de circuits ne comprenant que le circuit de base.

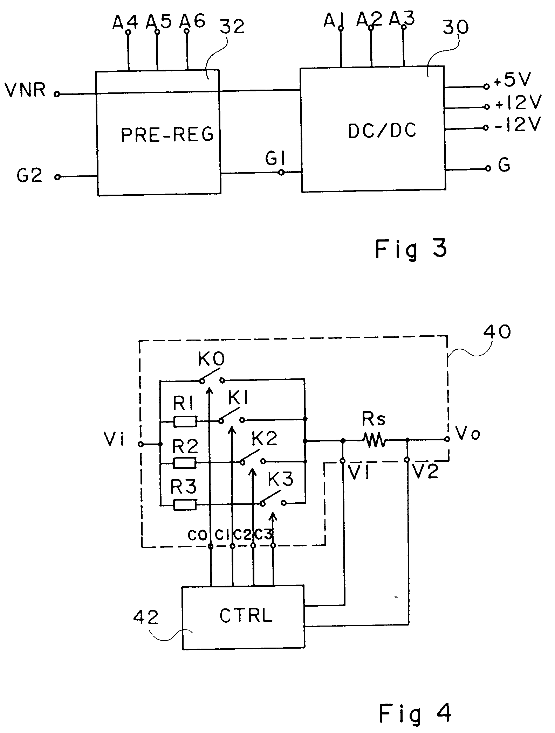

La figure 3 représente un exemple de circuit de base et de circuit secondaire que l'on est amené à monter dans un boîtier compact. Il s'agit d'un circuit d'alimentation comprenant, en tant que circuit de base, un convertisseur continu-continu 30. Ce convertisseur 30 comprend, par exemple, quatre bornes de sortie dont l'une, G, est une borne de masse et les trois autres délivrent par rapport à cette borne G des tensions de +5, +12 et -12 V, par exemple. La tension d'entrée du convertisseur 30 est appliquée entre une borne de masse G1 et une borne VNR. Il peut être prévu des bornes supplémentaires A1 à A3 servant, par exemple, à synchroniser la fréquence de hachage du convertisseur 30 sur une fréquence externe, à indiquer un état de surcharge...

Dans un boîtier selon l'invention, c'est le convertisseur 30 qui est monté sur le circuit imprimé 12. Toutes les bornes de ce convertisseur constituent les broches de connexion 12-2 du circuit imprimé 12. Le convertisseur 30 que l'on vient de décrire peut être utilisé seul dans un grand nombre d'applications. Toutefois, dans certaines applications, par exemple en aéronautique, la tension à convertir comprend un grand nombre de perturbations électriques qui peuvent induire des mauvais fonctionnements du convertisseur 30. Pour cela, il faut que le convertisseur 30 soit précédé d'un prérégulateur.

Ainsi, un circuit secondaire, à monter sur le circuit imprimé couvercle 14 comprend, dans cet exemple, un prérégulateur 32. La tension d'entrée du prérégulateur 32 est appliquée entre la borne VNR précédemment mentionnée, qui est commune au prérégulateur 32 et au convertisseur 30, et une borne de masse G2. La tension de sortie du prérégulateur 32 est appliquée entre la borne VNR et la borne de masse G1 du convertisseur 30. Le prérégulateur 32 peut également comporter des bornes supplémentaires A4 à A6 pour diverses fonctions supplémentaires non décrites. Les bornes du prérégulateur 32, non connectées à des bornes du convertisseur 30, constituent les broches de connexion 14-2 du circuit imprimé couvercle 14.

La figure 4 représente un autre exemple de circuit de base et de circuit secondaire à monter dans un boîtier compact. Il s'agit d'un circuit permettant d'appliquer à une charge un courant variable selon un gabarit temporel prédéterminé.

Le circuit de base 40 comprend des interrupteurs K0 à K3, parmi lesquels l'interrupteur K0 permet d'établir un contact direct entre une borne d'entrée Vi et une borne de sortie Vo, et les interrupteurs K1 à K3 permettent de mettre en série entre les bornes Vi et Vo des résistances respectives R1 à R3. Les interrupteurs K0 à K3 sont commandés par des bornes respectives C0 à C3. Une résistance shunt Rs est éventuellement prévue pour mesurer le courant circulant entre les bornes Vi et Vo, les bornes de cette résistance Rs étant reliées à des bornes V1 et V2.

Selon l'invention, le circuit de base 40 est monté sur le circuit imprimé 12 du boîtier compact.

Le circuit secondaire est un circuit de commande 42 relié aux bornes de commande C0 à C3 et mesurant la tension entre les bornes V1 et V2. Le circuit de commande 42 est différent selon le gabarit de courant que l'on veut respecter. Selon l'invention, ce circuit de commande 42 est monté sur le circuit imprimé couvercle 14.

## Revendications

1. Boîtier comprenant un circuit électronique de base (12-1) monté sur un circuit imprimé (12) muni de broches (12-2) destinées à connecter le circuit de base à des éléments externes au boîtier, le boîtier étant fermé par un couvercle isolant (14) muni de trous (14-1) traversés par lesdites broches, caractérisé en ce que le couvercle est un circuit imprimé sur lequel est monté un circuit électronique secondaire (15), lesdits trous étant métallisés de manière à permettre la connexion du circuit secondaire au circuit de base par l'intermédiaire desdites broches.

2. Boîtier selon la revendication 1, caractérisé en ce que le circuit imprimé (14) formant couvercle est muni de broches (14-2) destinées à connecter le circuit secondaire (15) à des éléments externes au boîtier.

3. Boîtier selon la revendication 1, caractérisé en ce que le circuit secondaire (15) comprend des composants montés en surface sur le circuit imprimé (14) formant couvercle, du côté intérieur du boîtier.

4. Boîtier selon la revendication 1, caractérisé en ce que le circuit secondaire (15) est optionnel.

5. Boîtier selon la revendication 4, caractérisé en ce que le circuit de base est un convertisseur continu-continu (30) et le circuit secondaire un prérégulateur (32) à relier à l'entrée du convertisseur continu-continu.

6. Boîtier selon la revendication 1, caractérisé en ce que le circuit de base est un réseau (40) de résistances commutables par des interrupteurs (K0-K2) et le circuit secondaire un circuit de commande (42) desdits interrupteurs.
